# EUROPEAN PATENT SPECIFICATION

(11) **EP 0 376 677 B1**
(45) Date of publication and mention of the grant of the patent: **12.05.1993**
(21) Application number: 89313587.1
(22) Date of filing: 27.12.1989
(51) Int. Cl.: A44B 19/34, G21F 1/12

(54) **Slide fastener chain for blocking electromagnetic radiation and method for production thereof**
Reissverschlusskette zum Absperren von elektromagnetischen Ausstrahlungen und Verfahren zum Herstellen von dieser Reissverschlusskette
Chaîne de fermeture à glissière destinée à enrayer le passage des radiations électromagnétiques et méthode pour fabriquer celle-ci

(30) Priority: 27.12.1988 JP 328008/88
(43) Date of publication of application: 04.07.1990
(73) Proprietor: YOSHIDA KOGYO K.K., Chiyoda-ku, Tokyo (JP)
(72) Inventor: Watanabe, Kozo, Kurobe-shi Toyama-ken (JP); Sugimoto, Yasuhiko, Kurobe-shi Toyama-ken (JP)
(74) Representative: White, Martin David

(56) References cited:
- WO-A-86/03050
- US-A- 2 522 072
- US-A- 4 514 586
- US-A- 4 546 497

## Description

This invention relates to a slide fastener chain for blocking electromagnetic radiation to be used as in connecting shielding means capable of intercepting electromagnetic radiation or waves such as disturbing waves and leaky waves and a method for the production thereof.

### Description of the Prior Art:

For the purpose of protecting household electric appliances, electric devices such as electric precision measuring instruments and high frequency-applied devices, and electric wires and cables against troubles caused by disturbing waves or for the purpose of preventing the leaking of high-frequency waves generated by such instruments, the practice of enclosing such electric devices in shield cages made of metallic nets and other materials which intercept electromagnetic waves or the practice of wrapping the electric wires and cables in covers made of materials capable of shielding electromagnetic waves is in vogue. In recent years, the troubles caused by electromagnetic waves generated as by office-automating (OA) devices have come to raise a problem. For the purpose of precluding this problem, efforts are continued to develop rooms for blocking electromagnetic radiation from such OA devices.

For the purpose of facilitating the opening and closing of such shield cages and shield rooms or the attachment and detachment of shield covers, slide fasteners are used to advantage. The slide fasteners which are used in connecting such shielding means against electromagnetic waves are desired to possess a function of themselves from electromagnetic waves.

As a slide fastener which, though not intended directly for the connection of such shielding means, is capable of blocking electromagnetic radiation, Japanese Patent Publication No. SHO 56(1981)-32,921, for example, discloses a slide fastener which has fastener elements attached to a fastener tape made of metallic fibers. This slide fastener is intended to exhibit an improved behavior in corrosion resistance, weathering resistance, durability, mechanical strength, etc. by using in the fastener tape thereof metallic fibers in the place of heretofore used synthetic fibers or natural fibers. The slide fastener which employs the fastener tape made of metallic fibers as described above, however, suffers from inferior flexibility and high cost. Further, the fact that the strength of attachment of the fastener element is insufficient entails the disadvantage that the element is not stabilized in its attached position and it is not easily attached with a fixed pitch. Japanese Utility Model Publication No. SHO 48(1973)-40,084 discloses a tape for use in a slide fastener, which tape comprises a woven fabric formed by using asbestos fibers and glass fibers respectively as warp and weft, an aluminum coating applied to the surface of the woven fabric by vacuum deposition, and a nonflammable core thread or string formed along the lateral edge of the woven fabric. This tape is intended to be used in slide fasteners for binding to the edges of an opening in fireproof garments or fireproof bags. It pays no respect to the shielding of the slide fastener from electromagnetic waves. Further, since the tape uses a woven fabric formed of nonflammable and nonstretchable inorganic fibers and an aluminum coating layer formed for tightly filling gaps in the texture of the fabric and covering the surface of the fabric, it has the disadvantage that it is deficient in flexibility and strentchability and expensive to manufacture.

A slide fastener chain which is intended solely for use in connecting parts of shielding means against electromagnetic waves is disclosed in Japanese Utility Model Application laid open to public inspection; KOKAI No. SHO 58(1983)-164,290. The slide fastener chain disclosed in the specification is produced by forming a folded part at one end of a shielding means against electromagnetic waves, forming a core string part by placing a flexible core member inside the folded part, and binding electroconductive fastener elements to the core string part as electrically connected to the shielding means. The slide fastener chain, therefore, is produced as attached to the shielding means. Since this slide fastener chain requires the core string part to be formed inside the folded part of the shielding means such as of a metallic net obtained by warp knitting a thin wire and binding the fastener elements to the core string part, however, it has the disadvantage that the attachment is troublesome and the flexibility is insufficient.

WO-A-8603050, on which the preamble of claim 1 is based, discloses a slide fastener chain capable of attenuating electromagnetic radiation, said slide fastener chain comprising:- a fastener tape made from synthetic fibres or from natural fibres, said fastener tape being coated with a first electroconductive layer of metal or alloy by electroless plating; and fastener elements attached along one lateral edge of said fastener tape.

WO-A-8603050 also discloses a method for the production of a slide fastener chain capable of attenuating electromagnetic radiation, said method comprising:- coating a fastener tape made from synthetic fibres or from natural fibres with a first electroconductive layer of metal or alloy by electroless plating; and attaching fastener elements along one lateral edge of said fastener tape. The preamble of claim 5 is based on this disclosure.

However, the slide fastener chain disclosed in WO-A-8603050 does not have electroconductive fastener elements.

Furthermore, WO-A-8603050 does not disclose coating the slide fastener tape with one or more additional electroconductive layers.

### SUMMARY OF THE INVENTION

An object of this invention, therefore, is to provide a slide fastener chain for shielding means, which slide fastener chain excels in flexibility and in ability to intercept electromagnetic waves.

Another object of this invention is to provide a slide fastener chain which permits as simple attachment of the fastener elements to a fastener tape as in any slide fastener chain of ordinary run and which allows lasting retention of the ability to intercept electromagnetic waves without entailing any such problem as separation of a metallic coating layer.

Yet another object of this invention is to provide a slide fastener chain which excels in ability to intercept electromagnetic waves, flexibility, corrosion resistance, and ability to keep an electroconductive plating layer attached fast to a tape of fibers.

A further object of this invention is to provide a method capable of producing relatively simply and relatively inexpensively a slide fastener chain excelling in flexibility, ability to intercept electromagnetic waves, etc. as described above.

According to a first aspect of the present invention there is provided a slide fastener chain capable of attenuating electromagnetic radiation, said slide fastener chain comprising:- a fastener tape made from synthetic fibres or from natural fibres, said fastener tape being coated with a first electroconductive layer of metal or alloy by electroless plating; and fastener elements attached along one lateral edge of said fastener tape;
said slide fastener chain being characterised in that it further comprises at least one additional electroconductive layer of metal or alloy applied onto said first electroconductive layer; and in that said fastener elements attached along one lateral edge of said fastener tape are electroconductive fastener elements.

According to a second aspect of the present invention there is provided a method for the production of a slide fastener chain capable of attenuating electromagnetic radiation, said method comprising:- coating a fastener tape made from synthetic fibres or from natural fibres with a first electroconductive layer of metal or alloy by electroless plating; and attaching fastener elements along one lateral edge of said fastener tape;
said method being characterised in it further comprises the steps of providing at least one further electroconductive layer of metal or alloy on said first electroconductive layer by electroless plating; and in that said fastener elements attached along one lateral edge of said fastener tape are electroconductive fastener elements
Particular embodiments of the invention are set out in dependent claims 2 to 4 and 6 to 9.

In the best mode of embodying the slide fastener chain and the method for production thereof, the electroconductive coating layer coated on the fastener tape comprises a three-ply (Ni/Cu/Ni) plating layer produced by sequentially coating nickel, copper, and nickel by electroless plating on the fastener tape made of synthetic fibers or natural fibers.

### DETAILED DESCRIPTION OF THE INVENTION

In accordance with this invention, a fastener tape is coated with a thin plating layer of an electroconductive metal or alloy by means of electroless plating and subsequently attaching electroconductive fastener elements to the coated fastener tape. The fastener tape, therefore, can be vested with electroconductivity without a sacrifice of the flexibility of the fibers as the raw material for the fastener tape and, consequently, the slide fastener chain to be produced excels in flexibility as well as in ability to intercept electromagnetic waves. There may be possibly conceived an idea of effecting the electroless plating after the fastener elements made of metal are attached to the fastener tape. This method, however, proves to be undesirable because it entails the problem that the components of the material of the fastener element dissolve out into the plating liquid and spoil the balance of composition of the plating liquid. It is, therefore, necessary to employ a procedure which comprises subjecting the fastener tape to electroless plating and thereafter performing the plating of the fastener elements in the fastener tape.

The metal which is deposited on the tape of fibers by the electroless plating is required only to be electroconductive. The metals answering this requirement may be broadly classified under the following two groups.
(A) Metals of Group VIII in Periodic Table of the Elements such as, for example, nickel, cobalt, and palladium which have a strong catalytic activity and alloys based on these metals.
(B) Metals of Group Ib such as, for example, copper, silver, and gold which betray a weak catalytic activity and yet possess a relatively noble electric potential.

The metals belonging to the two groups mentioned above are all usable. However, when a metal of the group of (A) enjoying a strong catalytic activity is used for the electroless plating, it is desirable to use a compound of a strong reducing power as a reducing agent. On the other hand, when a metal of the group of (B) betraying a weak catalytic activity is used, it is desirable to use a compound possessing a weak reducing power as a reducing agent. It is generally favorable to effect the electroless plating with nickel and copper by reason of economy.

Typical cases of effecting the electroless plating on fibers are as follows.
i) Electroless plating with Ni
ii) Electroless plating with Cu + electroless plating with Ni
iii) Electroless plating with Ni + electroless plating with Cu + electroless plating with Ni

In the case of the electroless plating solely with Ni, as disclosed in the prior art, the electroconductivity to be imparted is slightly inferior. In the case of the electroless plating with Cu + that with Ni indicated in ii), the plating with Cu serves to impart electroconductivity and the Ni plating layer superposed thereon serves to impart excellent corrosion resistance. Particularly in the case of the three-ply plating with Ni + Cu + Ni indicated in iii), the lowermost Ni plating layer serves to impart tight adhesiveness of the plating layer to the fibers, the intermediate Cu plating layer to impart electroconductivity, and the uppermost Ni plating layer to enhance corrosion resistance. Therefore, the electroless plating effected in this manner may well be called the optimum method of treatment for preparing the fastener tape capable of intercepting electromagnetic waves from both standpoints of attaining effective plating on a fastener tape made of fibers and effective impartation of electroconductivity thereto.

The electroless plating itself has been known to the art and can be carried out by any of the heretofore well known plating techniques. Generally, this plating is carried out in the electroless plating bath after such pretreatments as surface modification (etching), neutralization, and washing with water and a subsequent series of treatments such as the impartation of responsivity or sensitivity (generally by the use of a stannous chloride type sensitivity-imparting agent) performed for the purpose of facilitating the deposition of a catalytic coating and the catalytic activation or impartation of activity (generally by the use of a platinum-family metal represented by palladium or gold or silver as a catalizing agent or activating agent).

By the electroless plating described above, a very thin plating layer is deposited on individual fibers of the fastener tape. Though the fastener tape has a touch of slightly increased rigidity, it exhibits substantially the same flexibility as before the plating.

The fastener tape on which the electroless plating is performed may be any of the conventionally used fastener tapes made of synthetic fibers or natural fibers. The tapes formed by weaving or knitting yarns made of such synthetic fibers as polyester, polyurethane, nylon, polyacrylonitrile, and rayon and such natural fibers as cotton and silk may be mentioned as examples.

The fastener element to be attached to the fastener tape which has undergone the electroless plating described above may be any of the fastener elements made of electroconductive materials. The elements made of brass, aluminum, nickel, copper, etc. and the elements made of resin and plated with the metals mentioned above may be cited as examples. The individual teeth of the fastener element may be shaped in any of the heretofore conventionally known shapes. The L-shaped or zigzag type element, and the coil type element may be cited as examples.

In one lateral edge part of the fastener tape on which the electroconductive layer has been deposited as described above, a core string part is formed as generally practised in the art. To this core string part, the fastener elements are attached as spaced by a prescribed pitch. The slide fastener chain consequently obtained is further fitted with such necessary parts as slider, a top stop, and a bottom stop to give rise to a finished slide fastener of a prescribed length.

For more specific illustration of the present invention, the following examples are presented which are intended to be merely illustrative of and not in any sense limitative of the invention.

### Example 1:

The surface of a fastener tape made of polyester fibers was modified by an etching treatment performed in an aqueous 5% sodium hydroxide solution at a temperature in the range of 50° to 55°C for two minutes, then washed with water, neutralized in an aqueous 5% hydrochloric acid solution at normal room temperature for one minute, washed again with water, and treated with an aqueous solution of a tin-containing responsivity-imparting agent at a temperature in the range of 30° to 35°C for three minutes. The treated fastener tape was washed with water, treated with an aqueous solution of a palladium-containing catalyzing agent at a temperature near 36°C for three minutes, washed with water, subjected to electroless plating in a nickel plating bath at a temperature of 35°C and a pH 9.4 for two minutes, and washed with water. Subsequently, the Ni-plated fastener tape was subjected to electroless plating in a copper plating bath at a temperature in the range of 30° to 35°C for five minutes, then washed with water, treated with a palladium-containing catalyzing agent at 25°C for 30 seconds, washed with water, and subjected to electroless plating in a nickel plating bath at a temperature in the range of 35° to 38°C and a pH 9.4 for seven minutes. To the fastener tape thus plated, the fastener elements of brass were attached.

The slide fastener chain obtained as described above excelled in corrosion resistance and in ability to intercept electromagnetic waves and possessed the same flexibility as the fastener tape of ordinary run made of fibers. It further excelled in tight adhesiveness of the plating layer to the fibers. In actual use, it encountered any such problem as peeling of the plating layer. Further, since the fastener element has undergone no plating, the slide fastener chain has no possibility of the plating layer being removed by the movement of the slider, for example.

A slide fastener chain was produced by following the procedure of Example 1 described above, excepting the electroless plating was carried out under the conditions shown below. This slide fastener chain was similarly excellent in flexibility, corrosion resistance, and ability to intercept electromagnetic waves.
- Etching:: Aqueous 4-6% sodium hydroxide solution, 50° to 55°C, two to three minutes.
- Neutralization:: 4 to 6% HCl solution, normal room temperature, one to two minutes.
- Impartation of responsivity:: 30° to 35°C, three to five minutes.

- Catalytic activation:: 34° to 36°, two to four minutes. Electroless plating with nickel: pH 9 to 10, 35° to 38°C, one to two minutes.
- Electroless plating with copper:: 30°C to 35°C, four to seven minutes.
- Catalytic activation:: 25°C, 30 seconds.
- Electroless plating with nickel:: pH 9.4, 35° to 38°C, three to four minutes.

### Example 2:

After the treatments of surface modification, washing with water, neutralization, washing with water, impartation of responsivity, washing with water, catalytic activation, and washing with water were carried out in the same manner as in Example 1, a fastener tape was subjected to electroless plating in the same copper plating bath as used in Example 1 for seven minutes, washed with water, and then subjected to electroless plating in the same nickel plating bath as used in Example 1 at a pH 9.4 and a temperature in the range of 35° to 38°C for seven mintues. By attaching the fastener elements made of brass to the fastener tape consequently obtained, there was obtained a slide fastener chain excelling in flexibility, corrosion resistance, and ability to intercept electromagnetic waves.

## Claims

1. A slide fastener chain capable of attenuating electromagnetic radiation, said slide fastener chain comprising:- a fastener tape made from synthetic fibres or from natural fibres, said fastener tape being coated with a first electroconductive layer of metal or alloy by electroless plating; and fastener elements attached along one lateral edge of said fastener tape;
said slide fastener chain being characterised in that it further comprises at least one additional electroconductive layer of metal or alloy applied onto said first electroconductive layer; and in that said fastener elements attached along one lateral edge of said fastener tape are electroconductive fastener elements.

2. A slide fastener chain according to claim 1, wherein said first electroconductive layer is a Cu layer; and wherein a layer of Ni is formed on said first electroconductive layer of Cu.

3. A slide fastener chain according to claim 1, wherein said first electroconductive layer is an Ni layer;
wherein a layer of Cu is formed on said first electroconductive layer of Ni; and wherein a layer of Ni is formed on said layer of Cu.

4. A slide fastener chain according to any preceding claim, wherein each said electroconductive fastener element is an element made of metal or an element made of resin and plated with metal.

5. A method for the production of a slide fastener chain capable of attenuating electromagnetic radiation, said method comprising:- coating a fastener tape made from synthetic fibres or from natural fibres with a first electroconductive layer of metal or alloy by electroless plating; and attaching fastener elements along one lateral edge of said fastener tape;
said method being characterised in it further comprises the steps of providing at least one further electroconductive layer of metal or alloy on said first electroconductive layer by electroless plating; and in that said fastener elements attached along one lateral edge of said fastener tape are electroconductive fastener elements

6. A method for the production of a slide fastener chain according to claim 5, wherein said first electroconductive layer is a Cu layer; and wherein a layer of Ni is formed on said first electroconductive layer of Cu.

7. A method for the production of a slide fastener chain according to claim 5, wherein said first electroconductive layer is an Ni layer; wherein a layer of Cu is formed on said first electroconductive layer of Ni; and wherein a layer of Ni is formed on said layer of Cu.

8. A method according to any of claims 5 to 7, wherein said electroless plating includes a series of treatments such as etching, neutralization, impartation of responsivity, catalytic activation, and plating.

9. A method according to any of claims 5 to 8, wherein said electroconductive fastener element is an element made of metal or an element made of resin and plated with metal.

## Patentansprüche

1. Reißverschlußkette zur Abdämpfung elektromagnetischer Strahlung, umfassend: ein aus Kunst- oder Naturfasern hergestelltes Tragband, das durch stromloses Galvanisieren mit einer ersten elektrisch leitfähigen Schicht aus Metall oder einer Legierung beschichtet ist; und Kuppelglieder, die an einem Seitenrand des Tragbandes befestigt sind;
dadurch **gekennzeichnet**, daß mindestens eine zusätzliche elektrisch leitfähige Schicht aus Metall oder einer Legierung auf die besagte erste elektrisch leitfähige Schicht aufgebracht ist und daß die entlang einem Seitenrand den Tragbandes befestigten Kuppelglieder elektrisch leitfähige Kuppelglieder sind.

2. Reißverschlußkette nach Anspruch 1, wobei die erste elektrisch leitfähige Schicht eine Schicht aus Kupfer ist und wobei auf die besagte erste elektrisch leitfähige Schicht aus Kupfer eine Schicht aus Nickel aufgebracht ist.

3. Reißverschlußkette nach Anspruch 1, wobei die besagte erste elektrisch leitfähige Schicht eine Schicht aus Nickel ist, wobei eine Schicht aus Kupfer auf der besagten ersten elektrisch leitfähigen Schicht aus Nickel ausgebildet ist und wobei eine Schicht aus Nickel auf der besagten Schicht aus Kupfer ausgebildet ist.

4. Reißverschlußkette nach einem der vorhergehenden Ansprüche, wobei jedes der besagten elektrisch leitfähigen Kuppelglieder ein Kuppelglied ist, das aus Metall hergestellt ist oder aus Kunststoff hergestellt und mit Metall beschichtet ist.

5. Verfahren zur Herstellung einer Reißverschlußkette zur Abämpfung elektromagnetischer Strahlung, umfassend: Beschichten eines aus Kunst- oder Naturfasern hergestellten Tragbandes mit einer ersten elektrisch leitfähigen Schicht aus Metall oder einer Legierung durch stromloses Galvanisieren; und Anbringen von Kuppelgliedern entlang einem Seitenrand des Tragbandes;
dadurch **gekennzeichnet**, daß mindestens eine weitere elektrisch leitfähige Schicht aus Metall oder einer Legierung auf der besagten elektrisch leitfähigen Schicht durch stromloses Galvanisieren aufgebracht wird und daß die an einem Seitenrand des Tragbandes angebrachten Kuppelglieder elektrisch leitfähige Kuppelglieder sind.

6. Verfahren zur Herstellung einer Reißverschlußkette nach Anspruch 5, wobei die besagte erste elektrisch leitfähige Schicht eine Schicht aus Kupfer ist und wobei auf dieser ersten elektrisch leitfähigen Schicht aus Kupfer eine Schicht aus Nickel ausgebildet wird.

7. Verfahren zur Herstellung einer Reißverschlußkette nach Anspruch 5, wobei die besagte erste elektrisch leitfähige Schicht eine Schicht aus Nickel ist, wobei auf dieser ersten elektromagnetischen Schicht aus Nickel eine Schicht aus Kupfer ausgebildet wird und wobei auf dieser Schicht aus Kupfer eine Schicht aus Nickel ausgebildet wird.

8. Verfahren nach einem der Ansprüche 5 bis 7, wobei das stromlose Galvanisieren eine Reihe von Behandlungen umfaßt, wie Ätzen, Neutralisieren, Sensibilisieren, katalytisches Aktivieren und Galvanisieren.

9. Verfahren nach einem der Ansprüche 5 bis 8, wobei das elektrisch leitfähige Kuppelglied ein Kuppelglied ist, das aus Metall hergestellt ist oder aus Kunststoff hergestellt und mit Metall beschichtet ist.

## Revendications

1. Chaîne de fermeture à glissière apte à atténuer le rayonnement électromagnétique, ladite chaîne de fermeture à glissière comprenant : un ruban formé de fibres synthétiques ou de fibres naturelles, ledit ruban étant revêtu d'une première couche électro-conductrice d'un métal ou d'un alliage par placage non-électrolytique ; et des éléments d'accouplement fixés le long d'un des bords latéraux dudit ruban ;
la chaîne de fermeture à glissière sus-visée étant **caractérisée** en ce qu'elle comprend, en outre, au moins une couche supplémentaire électro-conductrice d'un métal ou d'un alliage appliquée sur la première couche électro-conductrice ; et en ce que les éléments d'accouplement fixés le long d'un des bords latéraux dudit ruban sont des éléments d'accouplement électro-conducteurs.

2. Chaîne de fermeture à glissière selon la revendication 1, dans laquelle la première couche électro-conductrice est une couche de Cu ; et dans laquelle une couche de Ni est formée sur ladite première couche électro-conductrice de Cu.

3. Chaîne de fermeture à glissière selon la revendication 1, dans laquelle la première couche électro-conductrice est une couche de Ni ; dans laquelle une couche de Cu est formée sur la première couche électro-conductrice de Ni ; et dans laquelle une couche de Ni est formée sur ladite couche de Cu.

4. Chaîne de fermeture à glissière selon l'une quelconque des revendications précédentes, dans laquelle chaque élément d'accouplement électro-conducteur est un élément formé d'un métal ou un élément formé d'une résine et plaqué de métal.

5. Procédé pour fabriquer une chaîne de fermeture à glissière apte à atténuer le rayonnement électromagnétique, le procédé sus-visé comprenant : le revêtement d'un ruban de fermeture à glissière formé de fibres synthétiques ou de fibres naturelles avec une couche électro-conductrice d'un métal ou d'un alliage formé par placage non-électrolytique ; et la fixation d'éléments d'accouplement le long d'un des bords latéraux dudit ruban de fermeture à glissière ;
le procédé sus-visé étant **caractérisé** en ce qu'il comprend, en outre, les étapes consistant à former au moins une autre couche électro-conductrice d'un métal ou d'un alliage sur ladite première couche électro-conductrice par placage non-électrolytique ; et en ce que lesdits éléments d'accouplement fixés le long d'un des bords latéraux du ruban de fermeture à glissière sont des éléments d'accouplement électro-conducteurs.

6. Procédé pour la fabrication d'une chaîne de fermeture à glissière selon la revendication 5, dans lequel la première couche électro-conductrice est une couche de Cu ; et dans lequel une couche de Ni est formée sur ladite première couche électro-conductrice de Cu.

7. Procédé pour la fabrication d'une chaîne de fermeture à glissière selon la revendication 5, dans lequel la première couche électro-conductrice est une couche de Ni ; dans lequel une couche de Cu est formée sur ladite première couche électro-conductrice de Ni ; et dans lequel une couche de Ni est formée sur ladite couche de Cu.

8. Procédé selon l'une quelconque des revendications 5 à 7, dans lequel le placage non-électrolytique comprend une série de traitements, tels qu'un décapage à l'acide, une neutralisation, une sensibilisation, une activation catalytique, et un placage.

9. Procédé selon l'une quelconque des revendications 5 à 8, dans lequel l'élément d'accouplement électro-conducteur est un élément formé d'un métal ou un élément formé d'une résine et plaqué d'un métal.
